Europäisches Patentamt

European Patent Office

Office européen des brevets

(11) Publication number: **0 183 052 B1**

# EUROPEAN PATENT SPECIFICATION

(45) Date of publication of patent specification: **27.12.91**  (51) Int. Cl.⁵: **C03C 17/36, C23C 14/00, G02B 1/10, G02B 5/26**

(21) Application number: **85113488.2**

(22) Date of filing: **24.10.85**

Divisional application 89113298.7 filed on 24/10/85.

(54) **Sputtered films of metal alloy oxides.**

(30) Priority: **29.10.84 US 665680**
**19.12.84 US 683458**

(43) Date of publication of application:
**04.06.86 Bulletin 86/23**

(45) Publication of the grant of the patent:
**27.12.91 Bulletin 91/52**

(84) Designated Contracting States:
**AT BE CH DE FR GB IT LI LU NL SE**

(56) References cited:
**EP-A- 0 035 906**
**EP-A- 0 120 408**
**FR-A- 2 430 986**
**US-A- 4 421 622**

(73) Proprietor: **PPG INDUSTRIES, INC.**
**One PPG Place**
**Pittsburgh Pennsylvania 15272(US)**

(72) Inventor: **Gillery, Frank Howard**
**2790 Indian Spring Lane**
**Allison Park Pennsylvania 15101(US)**

(74) Representative: **Sternagel, Hans-Günther, Dr.**
**et al**
**Patentanwälte Dr. Michael Hann Dr. H.-G.**
**Sternagel Sander Aue 30**
**W-5060 Bergisch Gladbach 2(DE)**

Rank Xerox (UK) Business Services

## Description

The present invention relates generally to the art of cathode sputtering of metal oxide films, and more particularly to the art of magnetic sputtering of multiple layer films of metal and metal oxide.

US -A- 4,094,763 to Gillery et al discloses producing transparent, electroconductive articles by cathode sputtering metals such as tin and indium onto refractory substrates such as glass at a temperature above 204°C (400°F) in a low pressure atmosphere containing a controlled amount of oxygen.

US -A- 4,113,599 to Gillery teaches a cathode sputtering technique for the reactive deposition of indium oxide in which the flow rate of oxygen is adjusted to maintain a constant discharge current while the flow rate of argon is adjusted to maintain a constant pressure in the sputtering chamber.

US -A- 4,166,018 to Chapin describes a sputtering apparatus in which a magnetic field is formed adjacent a planar sputtering surface, the field comprising arching lines of flux over a closed loop erosion region on the sputtering surface.

US -A- 4,201,649 to Gillery discloses a method for making low resistance indium oxide thin films by first depositing a very thin primer layer of indium oxide at low temperature before heating the substrate to deposit the major thickness of the conductive layer of indium oxide by cathode sputtering at typically high cathode sputtering temperatures.

US -A- 4,327,967 to Groth discloses a heat-reflecting panel having a neutral-color outer appearance comprising a glass pane, an interference film having a refractive index greater than 2 on the glass surface, a heat reflecting gold film over the interference film and a neutralization film of chromium, iron, nickel, titanium or alloys thereof over the gold film.

US -A- 4,349,425 to Miyake et al discloses d-c reactive sputtering of cadmium-tin alloys in argon-oxygen mixtures to form cadmium-tin oxide films having low electrical resistivity and high optical transparency.

US -A- 4,462,883 to Hart discloses a low emissivity coating produced by cathode sputtering a layer of silver, a small amount of metal other than silver, and an anti-reflection layer of metal oxide onto a transparent substrate such as glass. The anti-reflection layer may be tin oxide, titanium oxide, zinc oxide, indium oxide, bismuth oxide or zirconium oxide.

U.S. Reissue No. 27,473 to Mauer discloses a multilayer transparent article comprising a thin layer of gold or copper sandwiched between two layers of transparent material such as various metals, titanium oxide, lead oxide or bismuth oxide.

FR-A-2 430 986 discloses a multi-layer article, exhibiting high transmittance and a high infrared reflectivity comprising a substrate and thereon a metallic film sandwiched between two metal oxide layers. Both metal oxide layers are composed of oxides of the metals Bi, In, Sn, Zn, Cd or of alloys thereof.

In the interest of improving the energy efficiency of double-glazed window units, it is desirable to provide a coating on one of the glass surfaces which increases the insulating capability of the unit by reducing radiative heat transfer. The coating therefore must have a low emissivity in the infrared wavelength range of the radiation spectrum. For practical reasons, the coating must have a high transmittance in the visible wavelength range. For aesthetic reasons, the coating should have a low luminous reflectance and preferably be essentially colorless.

High transmittance, low emissivity coatings as described above generally comprise a thin metallic layer, for infrared reflectance and low emissivity, sandwiched between dielectric layers of metal oxides to reduce the visible reflectance. These multiple layer films are typically produced by cathode sputtering, especially magnetron sputtering. The metallic layer may be gold or copper, but is generally silver. The metal oxide layers described in the prior art include tin oxide, indium oxide, titanium oxide, bismuth oxide, zinc oxide, zirconium oxide and lead oxide. In some cases, these oxides incorporate small amounts of other metals, such as manganese in bismuth oxide, indium in tin oxide and vice versa, to overcome certain disadvantages such as poor durability or marginal emissivity. However, all of these metal oxides have some deficiency.

Although the coating may be maintained on an interior surface of a double-glazed window unit in use, where it is protected from the elements and environmental agents which would cause its deterioration, a durable effective coating able to withstand handling, packaging, washing and other fabrication processes encountered between manufacture and installation is particularly desirable. These properties are sought in the metal oxide. However, in addition to hardness which provides mechanical durability, inertness which provides chemical durability, and good adhesion to both the glass and the metal layer, the metal oxide should have the following properties as well.

The metal oxide must have a reasonably high refractive index, preferably greater than 2.0, to reduce the reflection of the metallic layer and thus enhance the transmittance of the coated product. The metal oxide must also have minimal absorption to maximize the transmittance of the coated product. For commercial reasons, the metal oxide should be reasonably priced, have a relatively fast deposition rate by magnetron sputtering, and be nontoxic.

Perhaps the most important, and most difficult to satisfy, requirements of the metal oxide film relate to its interaction with the metallic film. The metal oxide film must have low porosity, to protect the underlying metallic film from external agents, and low diffusivity for the metal to maintain the integrity of the separate layers. Finally, and above all, the metal oxide must provide a good nucleation surface for the deposition of the metallic layer, so that a continuous metallic film can be deposited with minimum resistance and maximum transmittance. The characteristics of continuous and discontinuous silver films are described in US -A- 4,462,884 to Gillery et al.

Of the metal oxide films in general use, zinc oxide and bismuth oxide are insufficiently durable, being soluble in both acid and alkaline agents, degraded by fingerprints, and destroyed in salt, sulfur dioxide and humidity tests. Indium oxide, preferably doped with tin, is more durable; however, indium sputters slowly and is relatively expensive. Tin oxide, which may be doped with indium or antimony, is also more durable, but does not provide a suitable surface for nucleation of the silver film, resulting in high resistance and low transmittance. The characteristics of a metal film which result in proper nucleation of a subsequently deposited silver film have not been established; however, trial-and-error experimentation has been widely practiced with the metal oxides described above.

It is the object of the invention to provide a multiple layer coating system on a transparent substrate which avoids the drawbacks of the known systems and which is more durable than the known sequences using the known metal oxide films.

This object is attained by a high transmittance, low emissivity article comprising

a. transparent nonmetallic substrate,

b. a first transparent film comprising metal alloy oxide on a surface of said substrate,

c. a transparent metallic film deposited on said first metal alloy oxide film and

d. a second transparent film comprising a metal oxide alloy oxide on said metallic film, characterized in that the first and second transparent metal alloy oxide film is the oxide reaction product of an alloy of zinc and tin.

The present invention provides a novel film composition of an oxide of a specific metal alloy, as well as a novel multiple-layer film of metal and metal alloy oxide layers for use as a high transmittance, low emissivity coating. The present invention provides further improved durability to such multiple-layer coatings by means of a primer layer which improves the adhesion between the metal and metal oxide layers.

## Detailed Description of the Preferred Embodiments

A novel film composition comprising an oxide of a specific metal alloy is preferably deposited by cathode sputtering, preferably magnetron sputtering. A cathode target is prepared comprising the desired ratio of metal alloy elements. The target is then sputtered in a reactive atmosphere, preferably containing oxygen in order to deposit a metal alloy oxide film on a surface of a substrate.

The metal alloy oxide in accordance with the present invention is an oxide of an alloy comprising zinc and tin. A zinc/tin alloy oxide film may be deposited in accordance with the present invention by cathode sputtering, preferably magnetically enhanced. Cathode sputtering is also a preferred method for depositing high transmittance, low emissivity films in accordance with the present invention. Such films typically comprise multiple layers, preferably a layer of a highly reflective metal such as gold, silver or copper sandwiched between anti-reflective metal oxide layers such as indium oxide or titanium oxide. In accordance with the present invention, the anti-reflective metal oxide layer comprises an oxide of an alloy of zinc and tin, and preferably comprises zinc stannate. While the characteristics of a metal alloy oxide film cannot always be predicted with respect to its performance in combination with a metallic film layer to form a high transmittance, low emissivity coating, various tests may be performed to determine its durability and, more importantly, its effectiveness in regard to nucleation of a silver film.

For durability, there are heat tests which measure changes in transmittance, reflectance and color of the coating as an indication of long-term stability, accelerated weathering and exposure tests which measure the effects of such environmental conditions as ultraviolet radiation, humidity and salt (fingerprints or coastal environment); a sulfur dioxide test to determine the susceptibility of the coating to damage by acidic atmospheric pollutants, and a test to determine whether the coating is damaged by a conventional glass washer and acidic or alkaline detergents.

More importantly, a nucleation test may be performed to evaluate the effects of the metal alloy oxide on the deposition of a metallic layer such as silver. To perform the nucleation test, a layer of the metal alloy oxide is deposited on a substrate surface. A given weight of silver per unit area of substrate surface is then deposited over the silver. Finally, a second layer of metal alloy oxide is deposited over the silver layer. The first effect to be evaluated is the decrease in transmittance as the silver is deposited: the less the decrease in transmittance, the lower the absorption and the better the nucleation. The second effect is the surface resistance of the multiple layer coating: the lower the resistance, the better the nucleation. The third effect is the final transmittance of the multiple layer coating: the higher the transmittance, the better the nucleation.

While various metal alloys may be sputtered to form metal alloy oxide films, in order to produce a preferred high transmittance, low emissivity multiple layer film in accordance with the present invention, alloys of tin and zinc are used. A particularly preferred alloy comprises zinc and tin, preferably in proportions of 10 to 90 percent zinc and 90 to 10 percent tin. A preferred zinc/tin alloy ranges from 30 to 60 percent zinc, preferably having a zinc/tin ratio from 40:60 to 60:40. A most preferred range is 46:54 to 50:50 by weight tin to zinc. A cathode of zinc/tin alloy reactively sputtered in an oxidizing atmosphere results in the deposition of a metal oxide layer comprising zinc, tin and oxygen, preferably comprising zinc stannate, $Zn_2SnO_4$.

In a conventional magnetron sputtering process, a substrate is placed within a coating chamber in facing relation with a cathode having a target surface of the material to be sputtered. Preferred substrates in accordance with the present invention include glass, ceramics and plastics which are not detrimentally affected by the operating conditions of the coating process.

The cathode may be of any conventional design, preferably an elongated rectangular design, connected with a source of electrical potential, and preferably employed in combination with a magnetic field to enhance the sputtering process. At least one cathode target surface comprises a metal alloy such as zinc/tin which is sputtered in a reactive atmosphere to form a metal alloy oxide film. The anode is preferably a symmetrically designed and positioned assembly.

In a preferred embodiment of the present invention, a multiple layer film is deposited by cathode sputtering to form a high transmittance, low emissivity coating. In addition to the metal alloy target, at least one other cathode target surface comprises a metal to be sputtered to form a reflective metallic layer. A multiple layer coating having a reflective metallic layer in combination with an anti-reflective metal alloy oxide layer is produced as follows.

A clean glass substrate is placed in a coating chamber which is evacuated, preferably to less than $133x10^{-4}$ Pa, more preferably less than $266X10^{-5}$ Pa. A selected atmosphere of inert and reactive gases, preferably argon and oxygen, is established in the chamber to a pressure between about $667X10^{-4}$ and $133x10^{-2}$ Pa. A cathode hav-

ing a target surface of zinc/tin metal alloy is operated over the surface of the substrate to be coated. The target metal is sputtered, reacting with the atmosphere in the chamber to deposit a zinc/tin alloy oxide coating layer on the glass surface.

After the initial layer of zinc/tin alloy oxide is deposited, the coating chamber is evacuated, and an inert atmosphere such as pure argon is established at a pressure between about $266X10^{-4}$ and $133x10^{-2}$ Pa. A cathode having a target surface of silver metal is operated over the zinc/tin alloy oxide coated surface. The target metal is sputtered and deposits a reflective, conductive metallic layer on the zinc/tin alloy oxide coated glass surface. A second layer of zinc/tin alloy oxide is deposited on the silver layer under essentially the same conditions used to deposit the first zinc/tin alloy oxide layer.

Preferably, at least one additional cathode target surface comprises a metal to be deposited as the primer layer. A durable multiple layer coating having a reflective metallic film in combination with an anti-reflective metal alloy oxide film is produced as follows, using primer layers to improve the adhesion between the metal and metal oxide films.

A clean glass substrate is placed in a coating chamber which is evacuated, preferably to less than $133x10^{-4}$ Pa, more preferably less than $266X10^{-5}$ Pa. A selected atmosphere of inert and reactive gases, preferably argon and oxygen, is established in the chamber to a pressure between about $667X10^{-4}$ and $133x10^{-2}$ Pa. A cathode having a target surface of zinc/tin metal alloy is operated over the surface of the substrate to be coated. The target metal is sputtered, reacting with the atmosphere in the chamber to deposit a zinc/tin alloy oxide coating layer on the glass surface.

After the initial layer of zinc/tin alloy oxide is deposited, the coating chamber is evacuated, and an inert atmosphere such as pure argon is established at a pressure between about $667X10^{-4}$ and $133x10^{-2}$ Pa. A cathode having a target surface of a metal such as copper is sputtered to deposit a primer layer over the zinc/tin alloy oxide layer. A cathode having a target surface of silver is then sputtered to deposit a reflective layer of metallic silver over the primer layer which improves the adhesion of the silver film to the underlying metal oxide film. An additional primer layer is then deposited by sputtering a metal such as copper over the reflective silver layer to improve the adhesion between the silver film and the overlying metal oxide film subsequently deposited. Finally, a second layer of zinc/tin alloy oxide is deposited over the second primer layer under essentially the same conditions used to deposit the first zinc/tin alloy oxide layer.

In most preferred embodiments of the present invention, a protective overcoat is deposited over the final metal oxide film. The protective overcoat is preferably deposited by sputtering over the metal oxide film a layer of a metal. Preferred metals for the protective overcoat include alloys of iron or nickel, such as stainless steel or Inconel. Titanium is a most preferred overcoat because of its high transmittance.

The present invention will be further understood from the descriptions of specific examples which follow. In the examples, the zinc/tin alloy oxide film is referred to as zinc stannate although the film composition need not be precisely $Zn_2SnO_4$.

## EXAMPLE I

A stationary cathode measuring 12.7 by 43.2 centimeters (5 by 17 inches) comprises a sputtering surface of zinc/tin alloy consisting of 52.4 weight percent zinc and 47.6 percent tin. A soda-lime-silica glass substrate is placed in the coating chamber which is evacuated to establish a pressure of 5.33 Pa in an atmosphere of 50/50 argon/oxygen. The cathode is sputtered in a magnetic field at a power of 1.7 kilowatts while the glass is conveyed past the sputtering surface at a rate of 2.8 meters (110 inches) per minute. A film of zinc stannate is deposited on the glass surface. Three passes produce a film thickness of about 0.034 μm (340 Angstroms), which results in a decrease in transmittance from 90 percent for the glass substrate to 81 percent for the zinc stannate coated glass substrate.

## EXAMPLE II

A multiple layer film is deposited on a soda-lime silica glass substrate to produce a high transmittance, low emissivity coated product. First, a zinc stannate layer is deposited as in Example I. Second, a layer of silver is deposited over the zinc stannate by sputtering a silver cathode target in an atmosphere of argon gas at a pressure of 5.33 Pa. With the substrate passing the silver cathode target at the same rate as in Example I, two passes are performed in order to deposit eleven micrograms of silver per square centimeter, corresponding to a film thickness of about 90 Angstroms, which decreases the transmittance of the coated substrate from 81 percent with the first zinc stannate film to 72 percent. Preferably, the silver is coated with a layer of zinc/tin alloy to improve the adhesion and protect the silver layer before the final anti-reflective layer of zinc stannate is deposited. Since the metal alloy further decreases the transmittance, its thickness is preferably minimal. The metal layer is deposited by sputtering the zinc/tin alloy target at minimum power in argon at a pressure of 5.33 Pa. The transmittance of the sample decreases to 60 percent after a single pass. Finally, the zinc/tin alloy cathode target is sputtered in an oxidizing atmosphere as in Example I to produce a zinc stannate film. Four passes at a rate of 2.8 meters (110 inches) per minute produce a film thickness of about 0.043 μm (430 Angstroms), which increases the transmittance of the coating product from 60 to 87 percent. The final coated product has a surface resistance of 10 ohms per square and a slightly bluish reflectance from both sides, with a luminous reflectance of 5 percent from the coated side and 6 percent from the uncoated side.

## EXAMPLE III

A multiple layer film is deposited on a soda-lime silica glass substrate to produce a high transmittance, low emissivity coated product. A stationary cathode measuring 12.7 by 43.2 centimeters (5 by 17 inches) comprises a sputtering surface of zinc/tin alloy consisting of 52.4 weight percent zinc and 47.6 percent tin. A soda-lime-silica glass substrate is placed in the coating chamber which is evacuated to establish a pressure of 5.33 Pa in an atmosphere of 50/50 argon/oxygen. The cathode is sputtered in a magnetic field at a power of 1.7 kilowatts while the glass is conveyed past the sputtering surface at a rate of 2.8 meters (110 inches) per minute. A film of zinc stannate is deposited on the glass surface. Three passes produce a film thickness of about 0.034 μm (340 Angstroms), resulting in a decrease in transmittance from 90 percent for the glass substrate to 83 percent for the zinc stannate coated glass substrate. A stationary cathode with a copper target is then sputtered to produce a copper primer layer over the zinc stannate, reducing the transmittance to about 80.6 percent. Next, a layer of silver is deposited over the copper primer layer by sputtering a silver cathode target in an atmosphere of argon gas at a pressure of 5.33 Pa. With the substrate passing under the silver cathode target at the same rate, two passes are necessary to deposit eleven micrograms of silver per square centimeter, corresponding to a film thickness of about 0.009 μm (90 Angstroms), decreasing the transmittance of the coated substrate to about 70.3 percent. A second copper primer layer is sputtered over the silver layer to improve the adhesion and protect the silver layer before the final anti-reflective layer of zinc stannate is deposited. Since the copper primer layers decrease the transmittance, their thicknesses are preferably minimal. The copper primer layers are deposited by sputtering a copper target at minimum power in argon at a pressure of 5.33 Pa. The transmittance of the sample decreases to 68.3 percent after deposition of the second copper primer layer. Finally, the zinc/tin alloy cathode target is sputtered in an oxidizing atmosphere to produce a zinc stannate film. Four passes at a rate of 2.8 meters (110 inches) per minute produce a film thickness of about 0.043 μm (430 Angstroms), increasing the transmittance of the coated product from 68.3 to 83.2 percent. The final coated product has a surface resistance of 10 ohms per square and a slightly bluish reflectance from both sides, with a luminous reflectance of 5 percent from the coated side and 6 percent from the uncoated side.

The improved durability of the coated article resulting from the improved adhesion between the metal and metal oxide films as a result of the primer layers of the present invention is readily demonstrated by a simple abrasion test consisting of wiping the coated surface with a damp cloth. A surface coated with zinc stannate/silver/zinc stannate having no primer layers in accordance with the present invention increases in reflectance from about 6 percent to about 18 percent after several passes of a damp cloth, indicating removal of both the top zinc stannate and the underlying silver films. In contrast, prolonged vigorous rubbing with a damp cloth produces no visible change in a zinc stannate/copper/silver/copper/zinc stannate coated article comprising the primer layers of the present invention.

The above examples are offered to illustrate the present invention. Various modifications of the product and the process are included. For example, other coating compositions are within the scope of the present invention. Depending on the proportions of zinc and tin when a zinc/tin alloy is sputtered, the coating may contain widely varying amounts of zinc oxide and tin oxide in addition to zinc stannate. Since the process does not require very high temperatures, substrates other than glass, such as various plastics, may be coated. A scanning cathode may be used with a stationary substrate, or both may be stationary. Process parameters such as pressure and concentration of gases may be varied over a broad range. The adhesion between a wide variety of metal and metal oxide films may be improved by means of primer layers in accordance with the present invention. Primer layers may comprise other metals such as indium, or oxides such as copper oxide or indium oxide. The scope of the present invention is defined by the following claims.

## Claims

1. A high transmittance, low emissivity article comprising

    a. a transparent nonmetallic substrate
    b. a first transparent film comprising metal alloy oxide on a surface of said substrate,
    c. a transparent metallic film deposited on said first metal alloy oxide film and
    d. a second transparent film comprising a metal oxide alloy oxide on said metallic film,
**characterized in that,**
the first and second transparent metal alloy oxide film is the oxide reaction product of an alloy of zinc and tin.

2. The article of claim 1 wherein the metal alloy comprises from 10 to 90 percent zinc.

3. The article of claim 2 wherein the metal alloy comprises from 30 to 60 percent zinc.

4. The article of claim 1 wherein the substrate is glass.

5. The article of claim 4 wherein the metallic film is silver.

6. The article of claim 1 wherein a further transparent film of metal alloy is deposited between the transparent metallic film (c) and the second transparent metal alloy oxide film (d).

7. The article of claim 6 wherein the transparent film of metal alloy comprises zinc and tin.

8. The article of claim 1 wherein a first primer layer is deposited between the first transparent film of metal alloy oxide (b) and the transparent reflective metallic film (c) and a second transparent primer layer is deposited between the transparent reflective metallic film (c) and the second transparent metal alloy oxide film (d).

9. The article of claim 8 wherein the primer films are selected from the group consisting of copper, indium and oxides thereof.

10. The article of claim 8 wherein each primer layer is of a thickness which decreases the transmittance of the article between 0.5 and 10 percent.

11. The article of claim 10 wherein the transmittance of the article is decreased between 1 and 5 percent by each primer layer.

12. A method for making a multiple layer high transmittance, low emissivity coated article by placing a transparent, non-metallic substrate in a sputtering chamber,

    (a) sputtering a cathode target comprising a metal alloy in a reactive atmosphere comprising oxygen to deposit a transparent metal alloy oxide film on a surface of said substrate,

(b) sputtering a silver cathode target to deposit a transparent silver film on said metal alloy oxide film and

(c) sputtering a cathode target comprising a metal alloy in a reactive atmosphere comprising oxygen to deposit a metal alloy oxide film on said silver film

**characterized in that**

the cathode target used for the metal alloy oxid layers is an alloy of zinc and tin and the silver cathode target is sputtered in an inert atmosphere.

13. The method of claim 12 wherein said substrate is glass.

14. The method of claim 12 wherein a further transparent metal alloy film is deposited by sputtering between said silver film and said second metal alloy oxide film.

15. The method of claim 12, wherein a metal target is sputtered to deposit a first primer layer on said first metal alloy oxide layer and to deposit a second primer layer on said silver film.

16. The method of claim 15 wherein said metal target is selected from copper or indium.

17. The method of claim 16 wherein the deposited primer layers are oxide from indium or copper.

18. The method of claim 12 to 17 wherein said sputtering is magnetically enhanced.

**Revendications**

1. Article à faible émissivité, à transmission élevée, comprenant

a. un support non métallique transparent,

b. un premier film transparent comprenant un oxyde d'un alliage métallique sur une surface du support précité,

c. un film métallique transparent déposé sur le premier film d'oxyde d'alliage métallique précité et

d. un second film transparent comprenant un oxyde d'un alliage métallique sur le film métallique précité,

caractérisé en ce que

le premier et le second films d'oxyde d'alliage métallique transparents sont les produits de la réaction oxydique d'un alliage du zinc et de l'étain.

2. Article suivant la revendication 1, caractérisé en ce que l'alliage métallique comprend de 10 a 90% de zinc.

3. Article suivant la revendication 2, caractérisé en ce que l'alliage métallique comprend de 30 a 60% de zinc.

4. Article suivant la revendication 1, caractérisé en ce que le support est en verre.

5. Article suivant la revendication 4, caractérisé en ce que le film métallique est en argent.

6. Article suivant la revendication 1, caractérisé en ce qu'un film transparent supplémentaire d'alliage métallique est déposé entre le film métallique transparent (c) et le second film d'oxyde d'alliage métallique transparent (d).

7. Article suivant la revendication 6, caractérisé en ce que le film transparent d'alliage de métal est constitué de zinc et d'étain.

8. Article suivant la revendication 1, caractérisé en ce qu'une première couche de fond ou primaire est déposée entre le premier film transparent d'oxyde d'alliage métallique (b) et le film métallique réflecteur transparent (c) et une seconde couche de fond ou primaire transparente est déposée entre le film métallique réflecteur transparent (c) et le second film d'oxyde d'alliage de métal transparent (d).

9. Article suivant la revendication 8, caractérisé en ce que les films de fond ou primaires sont choisis dans le groupe formé par le cuivre, l'indium et leurs oxydes.

10. Article suivant la revendication 8, caractérisé en ce que chaque couche de fond ou primaire possède une épaisseur qui réduit la transmission de l'article entre 0,5 et 10%.

11. Article suivant la revendication 10, caractérisé en ce que la transmission de l'article est réduite entre 1 et 5% par chaque couche de fond ou primaire.

12. Procédé de fabrication d'un article revêtu, de faible émissivité, à transmission élevée, multicouche en plaçant un support non métallique, transparent, dans une chambre de projection ou pulvérisation,

(a) on pulvérise une cible cathodique comprenant un alliage métallique dans une atmosphère réactive comprenant de l'oxygène afin de déposer un film d'oxyde d'alliage métallique transparent sur une surface du support précité,

(b) on pulvérise une cible cathodique d'argent pour déposer un film d'argent transparent sur le film d'oxyde d'alliage métallique précité et

(c) on pulvérise une cible cathodique comprenant un alliage métallique dans une atmosphère réactive comprenant de l'oxygène pour déposer un film d'oxyde d'alliage métallique sur ledit film d'argent,

caractérisé en ce que
la cible cathodique utilisée pour les couches d'oxyde d'alliage de métal est constituée d'un alliage du zinc et de l'étain et la cible cathodique d'argent est pulvérisée dans une atmosphère inerte.

13. Procédé suivant la revendication 12, caractérisé en ce que le support précité est en verre.

14. Procédé suivant la revendication 12, caractérisé en ce qu'un film d'alliage métallique transparent supplémentaire est déposé par pulvérisation ou projection entre le film d'argent précité et le second film d'oxyde d'alliage métallique précité.

15. Procédé suivant la revendication 12, caractérisé en ce qu'une cible métallique est pulvérisée ou projetée pour déposer une première couche de fond ou primaire sur ladite première couche d'oxyde d'alliage métallique et pour déposer une seconde couche de fond ou primaire sur le film d'argent précité.

16. Procédé suivant la revendication 15, caractérisé en ce que l'on choisit la cible métallique parmi le cuivre et l'indium.

17. Procédé suivant la revendication 16, caractérisé en ce que les couches de fond ou primaires déposées sont en oxyde d'indium ou de cuivre.

18. Procédé suivant les revendications 12 à 17, caractérisé en ce que l'on favorise magnétiquement la pulvérisation ou projection.

**Patentansprüche**

1. Gegenstand mit hoher Lichtdurchlässigkeit und niedrigem Emissionsvermögen, enthaltend
    a. einen transparenten, nichtmetallischen Träger,

b. einen ersten transparenten Film, enthaltend ein Metallegierungsoxid auf einer Oberfläche des Trägers,
c. einen auf dem ersten Metallegierungsoxidfilm abgeschiedenen transparenten Metallfilm,
d. einen zweiten transparenten Film, enthaltend ein Metallegierungsoxid auf dem Metallfilm,
**dadurch gekennzeichnet,**
daß der erste und zweite transparente Metallegierungsoxidfilm das Oxidationsreaktionsprodukt einer Zink-/Zinnlegierung sind.

2. Gegenstand nach Anspruch 1,
**dadurch gekennzeichnet,**
daß die Metallegierung von 10-90 % Zink enthält.

3. Gegenstand nach Anspruch 2,
**dadurch gekennzeichnet,**
daß die Metallegierung von 30-60 % Zink enthält.

4. Gegenstand nach Anspruch 1,
**dadurch gekennzeichnet,**
daß der Träger Glas ist.

5. Gegenstand nach Anspruch 4,
**dadurch gekennzeichnet,**
daß der Metallfilm aus Silber ist.

6. Gegenstand nach Anspruch 1,
**dadurch gekennzeichnet,**
daß ein weiterer transparenter Metallegierungsfilm zwischen dem transparenten Metallfilm (c) und dem zweiten transparenten Metallegierungsoxidfilm (d) abgeschieden ist.

7. Gegenstand nach Anspruch 6,
**dadurch gekennzeichnet,**
daß der transparente Metallegierungsfilm Zink und Zinn enthält.

8. Gegenstand nach Anspruch 1,
**dadurch gekennzeichnet,**
daß zwischen dem ersten transparenten Metallegierungsoxidfilm (b) und dem transparenten, reflektierenden Metallfilm (c) eine erste Grundierschicht abgeschieden ist und zwischen dem transparenten, reflektierenden Metallfilm (c) und dem zweiten transparenten Metallegierungsoxidfilm (d) eine zweite transparente Grundierschicht abgeschieden ist.

9. Gegenstand nach Anspruch 8,
**dadurch gekennzeichnet,**
daß die Grundierschichten ausgewählt sind aus der Gruppe, bestehend aus Kupfer, Indium und Oxiden derselben.

10. Gegenstand nach Anspruch 8,
**dadurch gekennzeichnet,**
daß jede Grundierschicht eine Dicke aufweist, die die Lichtdurchlässigkeit des Gegenstandes zwischen 0,5 und 10 % verringert.

11. Gegenstand nach Anspruch 10,
**dadurch gekennzeichnet,**
daß die Lichtdurchlässigkeit des Gegenstandes durch jede Grundierschicht zwischen 1 und 5 % verringert wird.

12. Verfahren zum Herstellen eines mehrfach beschichteten Gegenstandes mit hoher Lichtdurchlässigkeit und geringem Emissionsvermögen durch Anordnen eines transparenten, nichtmetallischen Trägers in einer Zerstäubungskammer,
(a) Zerstäuben einer Metallegierung enthaltenden Targetkathode in einer reaktiven, sauerstoffhaltigen Atmosphäre, um einen transparenten Metallegierungsoxidfilm auf einer Oberfläche des Trägers abzuscheiden,
(b) Zerstäuben einer Targetkathode aus Silber, um einen transparenten Silberfilm auf dem Metallegierungsoxidfilm abzuscheiden und
(c) Zerstäuben einer eine Metallegierung enthaltenden Targetkathode in einer reaktiven, sauerstoffhaltigen Atmosphäre, um einen Metallegierungsoxidfilm auf dem Silberfilm abzuscheiden,
**dadurch gekennzeichnet,**
daß die für die Metallegierungsoxidschichten verwendete Targetkathode eine Zink-/Zinnlegierung ist und das Kathodentarget aus Silber in einer inerten Atmosphäre zerstäubt wird.

13. Verfahren nach Anspruch 12,
**dadurch gekennzeichnet,**
daß der Träger Glas ist.

14. Verfahren nach Anspruch 12,
**dadurch gekennzeichnet,**
daß ein weiterer transparenter Metallegierungsfilm zwischen dem Silberfilm und dem zweiten Metallegierungsoxidfilm durch Zerstäuben abgeschieden wird.

15. Verfahren nach Anspruch 12,
**dadurch gekennzeichnet,**
daß ein Metalltarget zerstäubt wird, um eine erste Grundierschicht auf der ersten Metallegierungsoxidschicht abzuscheiden und eine zweite Grundierschicht auf dem Silberfilm.

16. Verfahren nach Anspruch 15,
**dadurch gekennzeichnet,**
daß das Metalltarget aus Kupfer oder Indium ausgewählt ist.

17. Verfahren nach Anspruch 16,
**dadurch gekennzeichnet,**
daß die abgeschiedenen Grundierschichten Oxide von Indium oder Kupfer sind.

18. Verfahren nach Ansprüchen 12-17,
**dadurch gekennzeichnet,**
daß das Zerstäuben magnetisch unterstützt wird.